# FASCICULE DE BREVET EUROPEEN

(11) **EP 2 906 958 B1**
(45) Date de publication et mention de la délivrance du brevet: **09.11.2016**
(21) Numéro de dépôt: 13776783.6
(22) Date de dépôt: 11.10.2013
(51) Int. Cl.: G01R 13/34

(54) **DISPOSITIF D'ÉCHANTILLONNAGE ÉLECTRO-OPTIQUE D'UN SIGNAL HYPERFRÉQUENCE.**
VORRICHTUNG ZUR ELEKTROOPTISCHEN ABTASTUNG EINES MIKROWELLENFREQUENZSIGNALS
DEVICE FOR ELECTRO OPTICAL SAMPLING OF A MICROWAVE FREQUENCY SIGNAL

(30) Priorité: 11.10.2012 FR 1202715
(43) Date de publication de la demande: 19.08.2015
(73) Titulaire: THALES, 92200 Neuilly-sur-Seine (FR); Université Paris 6 Pierre et Marie Curie UPMC, 75005 Paris (FR)
(72) Inventeur: COMBRIÉ, Sylvain, F-91767 Palaiseau Cedex (FR); DE ROSSI, Alfredo, F-91767 Palaiseau Cedex (FR); TRIPON, Charlotte, F-75252 Paris Cedex 05 (FR); CHAZELAS, Jean, F-78851 Elancourt (FR)
(74) Mandataire: Lavoix
(86) Numéro de dépôt international: PCT/EP2013/071281
(87) Numéro de publication internationale: WO 2014/057090

(56) Documents cités:
- J-M DELORD ET AL: "Sampling of RF signals with LTG-GaAs based MSM structures", LASERS AND ELECTRO-OPTICS, 2007 AND THE INTERNATIONAL QUANTUM ELECTRON ICS CONFERENCE. CLEOE-IQEC 2007. EUROPEAN CONFERENCE ON, IEEE, PI, 1 juin 2007 (2007-06-01), pages 1-1, XP031162925, ISBN: 978-1-4244-0930-3
- HANNAH J JOYCE ET AL: "III V semiconductor nanowires for optoelectronic device applications", PROGRESS IN QUANTUM ELECTRONICS, vol. 35, no. 2, 9 avril 2011 (2011-04-09), pages 23-75, XP028374313, ISSN: 0079-6727, DOI: 10.1016/J.PQUANTELEC.2011.03.002 [extrait le 2011-04-09]
- ITATANI T ET AL: "Ultrafast photoconductive switches fabricated by nano-anodization process on nano-clusters of InGaAs", CONFERENCE ON LASERS AND ELECTRO-OPTICS. (CLEO 2002). TECHNICAL DIGEST. POSTCONFERENCE EDITION. LONG BEACH, CA, MAY 19 - 24, 2002; [TRENDS IN OPTICS AND PHOTONICS. (TOPS)], WASHINGTON, WA : OSA, US, 19 mai 2002 (2002-05-19), pages 661-661, XP010607192, ISBN: 978-1-55752-706-6

## Description

La présente invention concerne un dispositif d'échantillonnage électro-optique d'un signal hyperfréquence comprenant une ligne de transmission d'un signal hyperfréquence.

L'invention se situe dans le domaine de l'échantillonnage électro-optique des signaux hyperfréquences, dont la bande de fréquence est de l'ordre de quelques gigahertz (GHz) à quelques centaines de GHz. De nombreuses applications dans les domaines des télécommunications et des radars utilisent de tels signaux hyperfréquences.

Il est connu de J-M Delord European Conference on Lasers & Electro-Optics and the International Quantum Electronics Conference : CLEO/Europe Munich, Germany, 17 - 22 June 2007 d'utiliser pour l'échantillonnage des signaux hyperfréquences, acheminés par ligne hyperfréquence interrompue, un interrupteur commandé par signal optique de référence, ou « porte » optique ultra-rapide, qui commute entre un état « ouvert » et un état « fermé » à des instants bien précis, de manière cadencée, afin d'échantillonner le signal électrique hyperfréquence. On utilise un laser à verrouillage de modes pour la génération du signal optique de commande, afin de réduire la gigue temporelle. Un tel interrupteur à commande par signal optique doit avoir un temps de réponse rapide, de l'ordre de la picoseconde.

A l'heure actuelle on connaît des interrupteurs à commande optique fabriqués en matériau semi-conducteur GaAs épitaxié à basse température, qui a une bande électronique interdite de 1,43eV. Ce semi-conducteur est rendu conducteur par un signal optique de longueur d'onde 0,8µm, de puissance élevée. Un laser à verrouillage de modes émettant à 0,8µm est relativement coûteux, et de plus, une puissance crête très élevée est nécessaire pour que l'interrupteur soit efficace.

Diverses études ont porté sur la mise au point d'un interrupteur à commande optique sensible à la longueur d'onde 1,5µm, tirant profit des composants moins coûteux tels les lasers et du savoir-faire, développé dans le domaine des télécommunications. En particulier, l'utilisation de semi-conducteurs à plus faible bande électronique interdite a été étudiée.

Cependant, le temps de recombinaison des porteurs générés dans de tels semi-conducteurs est généralement insuffisant pour atteindre la contrainte d'un temps de commutation de l'ordre de la picoseconde ou alors au prix de performances dégradées tel un courant d'obscurité important.

Il est souhaitable de pallier les inconvénients des systèmes existants, en proposant un interrupteur à commande optique pour ligne hyperfréquence qui soit plus efficace, donc qui nécessite un signal de commande à puissance moins élevée, tout en ayant un temps de commutation de l'ordre de la picoseconde.

A cet effet, l'invention propose un dispositif d'échantillonnage électro-optique d'un signal hyperfréquence comprenant une ligne hyperfréquence de transmission d'un signal hyperfréquence, ladite ligne hyperfréquence comportant une zone d'interruption apte à être rendue conductrice sous l'effet d'un signal optique de commande de manière à réaliser une fonction d'interrupteur à commande optique.

Le dispositif d'échantillonnage électro-optique comporte, dans ladite zone d'interruption, une couche en matériau semi-conducteur nanostructuré, comportant un pavage périodique ou quasi-périodique de nanostructures, ledit matériau semi-conducteur ayant un indice de réfraction, ladite couche en matériau semi-conducteur nanostructuré étant posée, au niveau de ladite zone d'interruption, en suspension ou sur un matériau diélectrique d'indice de réfraction inférieur à l'indice de réfraction du matériau semi-conducteur, ladite couche en matériau semi-conducteur nanostructuré étant apte à réaliser ladite fonction d'interrupteur à commande optique.

Avantageusement, le dispositif d'échantillonnage électro-optique selon l'invention comporte un interrupteur à commande par signal optique réalisé à l'aide d'une couche fine en matériau semi-conducteur nanostructuré, ce qui permet de renforcer le confinement de la lumière apportée par le signal de commande et par conséquent de diminuer la puissance nécessaire pour produire le déclenchement de la conduction électrique, et donc la fermeture de l'interrupteur. De plus, la nanostructuration augmente le rapport surface / volume de matériau semi-conducteur, et permet ainsi d'augmenter la vitesse de recombinaison des porteurs générés et donc la vitesse de commutation de l'interrupteur.

Selon une caractéristique, la couche en matériau semi-conducteur nanostructuré comporte au moins une cavité optique résonante formée par modification dans le pavage de nanostructures.

Avantageusement, l'utilisation d'une ou plusieurs cavités optiques résonantes permet d'obtenir des effets de non-linéarité, notamment une absorption à deux photons, ce qui permet l'utilisation d'un signal optique de commande à 1,5µm.

Le dispositif d'échantillonnage électro-optique selon l'invention peut présenter une ou plusieurs des caractéristiques ci-dessous, prises indépendamment ou en combinaison:
- lesdites nanostructures sont des trous, et ladite modification consiste en une omission, un changement de diamètre ou un déplacement par rapport au pavage d'au moins un trou ;
- ladite modification consiste en une omission localisée ou périodique d'un ou de plusieurs trous du pavage ;
- ledit pavage est une répétition périodique de motifs hexagonaux, le dispositif comportant une pluralité de cavités résonantes formées par omission du trou central de chaque motif hexagonal ;
- ladite cavité optique résonante permet une absorption linéaire ou non-linéaire pour un signal optique de commande de longueur d'onde comprise dans une plage de 0,8µm à 1,6µm ;
- ladite cavité optique résonante comporte un dispositif de couplage apte à favoriser l'absorption d'un signal optique de commande d'incidence normale par rapport à la couche en matériau semi-conducteur nanostructuré ;
- le matériau semi-conducteur formant ladite couche est un alliage de la famille de semi-conducteurs III-V ;
- ladite couche en matériau semi-conducteur nanostructuré a une épaisseur comprise dans une plage de 100 à 400 nanomètres ;
- ledit pavage a une période associée, ladite période étant choisie en fonction de la longueur d'onde du signal optique de commande et de l'indice de réfraction du matériau semi-conducteur formant la couche en matériau semi-conducteur nanostructuré.

D'autres caractéristiques et avantages de l'invention ressortiront de la description qui en est donnée ci-dessous, à titre indicatif et nullement limitatif, en référence aux figures annexées, parmi lesquelles :
- la figure 1 est un exemple schématique d'une chaîne d'échantillonnage électro-optique ;
- la figure 2 est une vue schématique en perspective d'un dispositif d'échantillonnage électro-optique ;
- la figure 3 est une vue en coupe d'un dispositif d'échantillonnage électro-optique selon un premier mode de réalisation de l'invention ;
- la figure 4 est une vue en coupe d'un dispositif d'échantillonnage électro-optique selon un deuxième mode de réalisation de l'invention ;
- la figure 5 est une vue de dessus d'un dispositif d'échantillonnage électro-optique selon un troisième mode de réalisation, ayant une cavité optique résonante à commande optique par guide d'onde ;
- la figure 6 est une vue de dessus d'un dispositif d'échantillonnage électro-optique selon un quatrième mode de réalisation, ayant une cavité optique résonante avec commande optique par incidence normale ;
- la figure 7 est une vue de dessus d'un dispositif d'échantillonnage électro-optique selon un cinquième mode de réalisation de l'invention, et
- la figure 8 est une vue de dessus d'un dispositif d'échantillonnage électro-optique selon un sixième mode de réalisation de l'invention.

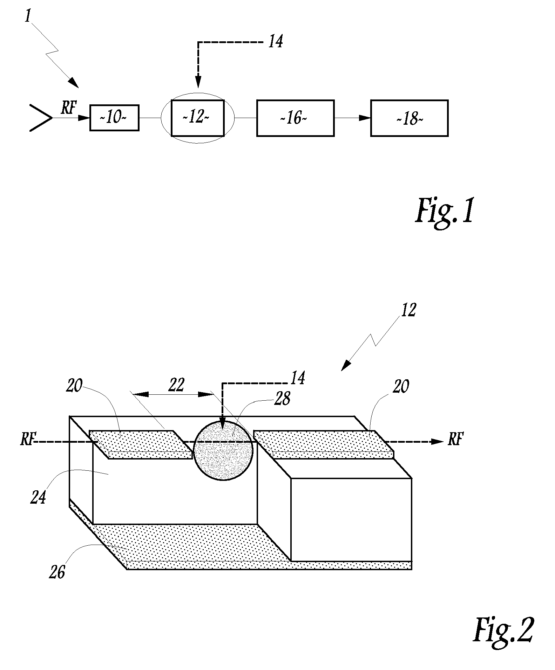

La figure 1 représente une chaîne de conversion analogique/numérique 1, dans laquelle un signal hyperfréquence RF arrive en entrée d'un filtre 10 adapté à filtrer ce signal dans une bande de fréquence prédéterminée. Un dispositif d'échantillonnage électro-optique 12, noté S/H pour « sample and hold », commandé par des impulsions optiques 14, envoyées périodiquement par exemple par un laser à verrouillage de modes, permet d'échantillonner le signal RF filtré. Le signal optique 14 est un signal d'horloge qui cadence l'échantillonnage du signal RF filtré. Typiquement, la cadence d'un tel signal est de l'ordre de quelques dizaines de GHz. Le signal échantillonné obtenu est envoyé à un convertisseur analogique-numérique 16, et le signal numérique obtenu est envoyé à un processeur de signal 18.

De nombreuses applications, en particulier dans le domaine des télécommunications et des radars, sont susceptibles d'utiliser une telle chaîne de traitement électro-optique réalisant une conversion analogique/numérique de signal hyperfréquence.

La figure 2 détaille le dispositif d'échantillonnage électro-optique 12, qui est un interrupteur à commande optique pour ligne hyperfréquence dans un mode de réalisation.

Dans ce mode de réalisation, le signal hyperfréquence RF est acheminé sur une ligne de transmission 20 dite ligne hyperfréquence, qui est interrompue sur une zone centrale d'interruption 22 de largeur Lg. La ligne hyperfréquence 20 en matériau conducteur métallique repose sur un substrat semi-conducteur 24. Dans le cas d'une ligne de propagation hyperfréquence dans une configuration micro-ruban, l'ensemble repose sur une couche conductrice électriquement 26 faisant office de plan de masse. Dans le cas d'une ligne de transmission hyperfréquence dans une configuration coplanaire, qui est une variante bien connue à la configuration micro-ruban, le plan de masse se situe de part est d'autre de la ligne de transmission.

Dans la zone centrale d'interruption 22, la zone 28, représentée de manière non limitative sous forme sphérique, est la zone devenant conductrice par éclairage par un signal optique 14.

Ainsi, lorsqu'un signal optique de puissance et de longueur d'onde appropriées, envoyé selon un angle incident donné, éclaire la zone 22, la zone 28 devient conductrice : lorsque la lumière est absorbée, des porteurs (électrons ou trous) sont libérés et se déplacent pour se recombiner, ce qui rend la zone 28 conductrice entre les deux portions de la ligne hyperfréquence 20, qui devient une ligne de transmission continue, la zone centrale d'interruption 22 ayant alors un fonctionnement d'interrupteur à commande optique fermé.

A l'inverse, lorsque la zone 22 n'est pas éclairée par un signal optique, la zone 28 est non conductrice, avec de préférence un courant d'obscurité faible ce qui garantit une résistance importante à l'état non conducteur.

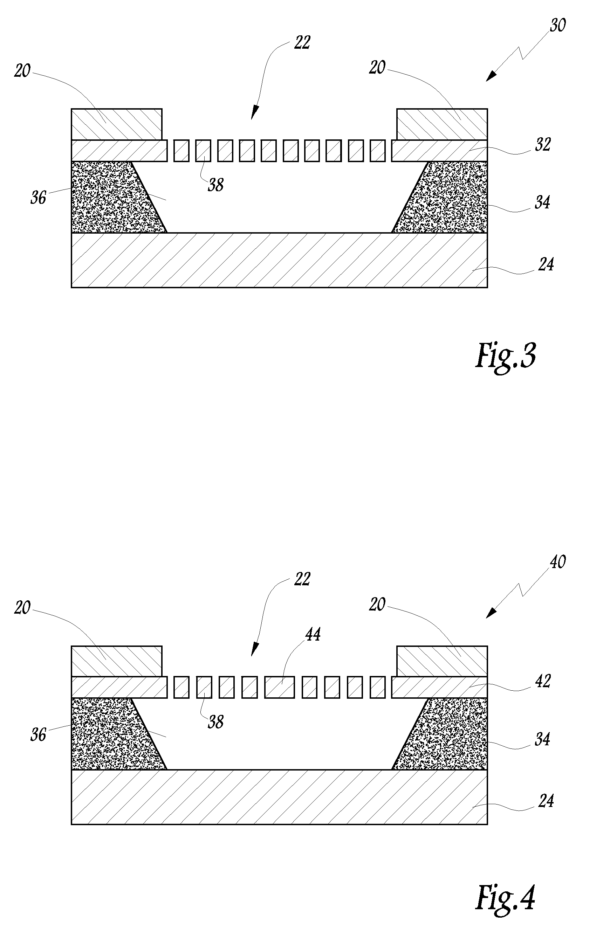

Selon l'invention, la fonction d'interrupteur à commande optique est réalisée par insertion d'une couche en matériau semi-conducteur nanostructuré, la nanostructuration étant présente sur au moins une portion de la zone d'interruption 22 située entre les deux parties de la ligne hyperfréquence, comme représenté dans les exemples des figures 3 à 8.

Ainsi, selon un premier mode de réalisation illustré à la figure 3, un dispositif électro-optique d'échantillonnage 30 comporte une couche 32 en matériau semi-conducteur, comportant une nano-structuration au niveau de la zone d'interruption 22, sur au moins une portion de la zone comprise entre les deux extrémités de la ligne hyperfréquence 20, de part et d'autre de la zone d'interruption. La couche 32 est insérée entre la ligne hyperfréquence 20 et la couche de substrat en matériau semi-conducteur 24.

Dans ce mode de réalisation, la couche en matériau nano-structuré 32 repose sur une couche sacrificielle 34 au niveau des parties conductrices hyperfréquence 20. La couche sacrificielle 34 est en matériau diélectrique.

La couche 32 en matériau nano-structuré est suspendue, donc entourée d'air en dessous et au dessus. De manière plus générale, la couche 32 repose sur un matériau diélectrique 36 dont l'indice de réfraction est inférieur à l'indice de réfraction du matériau semi-conducteur formant la couche 32, par exemple SiO₂, SiN, Al₂O₃. Dans ce cas, la couche sacrificielle 34 peut être dans le même matériau diélectrique 36.

Un tel matériau diélectrique 36 de faible indice peut également être posé au-dessus de la couche 32. Selon une variante, les trous sont remplis d'un matériau diélectrique de faible indice de réfraction, analogue au matériau diélectrique 36 décrit ci-dessus.

Le matériau semi-conducteur de la couche 32 est un matériau de la famille des alliages semi-conducteurs III-V, de préférence de l'arséniure de gallium (GaAs) ou du phosphure d'indium (InP), ou des alliages III-V en accord de maille avec le GaAs ou l'InP.

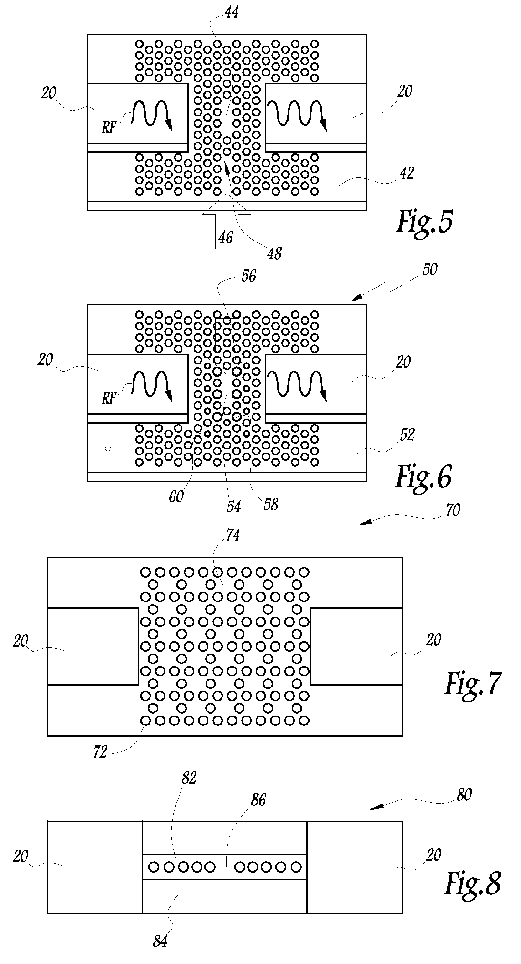

Les nanostructures 38 sont de préférence des trous, formés dans une membrane du matériau semi-conducteur du type mentionné ci-dessus, répétés selon un pavage périodique ou quasi-périodique, comme illustré ci-après, notamment à la figure 5.

Le motif du pavage est de préférence de type hexagonal. En variante, le motif du pavage est carré ou une combinaison de type pavage de Penrose.

La période du pavage *a*, qui est la distance entre les centres de deux trous consécutifs selon une direction, est comprise entre 250 et 600 nanomètres (nm). Le diamètre des trous est de l'ordre de 0,4 à 0,8 fois la période *a*. Il est à noter que dans cet exemple les trous ont une section circulaire, mais en variante, d'autres formes géométriques sont envisageables. La forme circulaire présente néanmoins l'avantage de la facilité de réalisation.

Afin d'obtenir un renforcement de l'absorption d'énergie du signal de commande optique au niveau de la nanostructuration, de préférence la période *a* est de l'ordre de λ/n, où λ est la longueur d'onde du signal optique de commande et n l'indice de réfraction du matériau semi-conducteur formant la couche 32. La période de répétition des nanostructures est donc de préférence choisie en fonction de la longueur d'onde du signal optique de commande.

La membrane formant la couche 32 a une épaisseur comprise entre 130 nm et 400 nm, par exemple une épaisseur de 200 nm. D'une manière générale, l'épaisseur de la membrane est de l'ordre de 0,3 à 1 fois la période *a*.

Avantageusement, la nanostructuration permet d'accélérer le processus d'absorption linéaire lorsque le matériau semi-conducteur est commandé par un signal de commande optique à longueur d'onde correspondant à la longueur d'onde absorbée par le matériau. Ainsi, le fonctionnement est amélioré même lorsque le semi-conducteur utilisé est le GaAs, à absorption à 0,8 µm.

De plus, la nanostructuration permet d'augmenter la vitesse de recombinaison des porteurs photo-générés, du fait de l'augmentation du rapport surface/volume, ce qui résulte en un fonctionnement plus rapide du dispositif d'échantillonnage 30 à interrupteur à commande optique.

Dans un deuxième mode de réalisation illustré à la figure 4, un dispositif électro-optique d'échantillonnage 40 selon l'invention permet une utilisation avec un signal optique de commande de longueur d'onde égale à 1,5µm.

Dans le mode de réalisation illustré à la figure 4, la couche en matériau nano-structuré 42 comporte une cavité optique résonante 44, formée par modification localisée du pavage ou insertion d'un défaut dans le pavage, ici par omission d'un trou entre deux nanostructures 38.

En variante, une cavité optique résonante est obtenue par modification localisée de la taille des nanostructures ou par déplacement des nanostructures, donc par modification locale de la période des nanostructures.

La cavité optique résonante permet un confinement local du champ électromagnétique et un effet d'absorption non linéaire à deux photons. L'absorption à deux photons est réalisée par une excitation par signal optique à longueur d'onde 1,5µm uniquement dans la zone d'interruption 22 entre les deux parties 20 de la ligne hyperfréquence, autour de la cavité optique résonante 44, puisque le matériau semi-conducteur formant la couche 42 ne présente pas d'absorption à cette longueur d'onde.

Avantageusement, le signal de commande optique agit de manière localisée et efficace au niveau de la zone d'interruption 22, l'effet de libération de porteurs étant atteint dès que la puissance de crête du signal optique de commande atteint 100 mW.

La figure 5 illustre un troisième mode de réalisation, correspondant au mode de réalisation de la figure 4 en vue de dessus, avec une couche nanostructurée 42 dont le pavage est à motif hexagonal.

Comme illustré sur la figure 5, le signal de commande optique 46 est acheminé par un guide d'onde 48 dans le plan de la couche nanostructurée 42. Le guide d'onde 48 est réalisé par une ligne de trous manquants, comme illustré dans la figure 5.

Dans une variante, le signal de commande peut-être acheminé par un guide d'onde se situant dans un plan sous-jacent.

En variante, selon un quatrième mode de réalisation illustré à la figure 6, un dispositif électro-optique 50 selon l'invention comporte une couche nanostructurée 52 ayant une cavité résonante 54 située dans la zone d'interruption de la ligne hyperfréquence, réalisée par omission de trous comme dans le mode de réalisation illustré à la figure 3. Le signal optique de commande 56 est acheminé à incidence normale, selon une direction sensiblement perpendiculaire à la couche nanostructurée 52, le couplage étant réalisé par application de la technologie dite de repliement de bandes ou « band folding » décrite notamment dans la demande de brevet EP2144099. Cette technologie consiste à modifier localement la taille des nanostructures autour de la cavité optique résonante 46, afin de créer localement un repliement de bandes pour concentrer un maximum d'énergie dans un cône de directivité très resserré. Ainsi, comme on peut le voir figure 6, des trous 58 de plus grand diamètre que les trous du pavage régulier et des trous 60 de plus petit diamètre que les trous du pavage régulier sont réalisés dans la membrane en semi-conducteur formant la couche nanostructurée 52. Ces trous 58, 60 forment un dispositif de couplage, ajouté à la cavité résonante 54 et favorisant l'absorption de photons d'un signal optique à incidence normale.

En variante, d'autres modes de réalisation d'un tel dispositif de couplage que celui illustré à la figure 6 sont mis en oeuvre.

Selon un cinquième mode de réalisation illustré à la figure 7 qui représente un dispositif électro-optique 70 selon l'invention en vue du dessus, la couche nanostructurée 72 comporte une pluralité de cavités optiques résonantes 74. Les cavités sont obtenues par omission systématique du trou central dans un pavage régulier hexagonal, selon une structure de type graphite. Dans ce mode de réalisation, chaque trou manquant agit comme une cavité résonante unique.

Selon un sixième mode de réalisation illustré à la figure 8 qui représente un dispositif électro-optique 80 selon l'invention en vue du dessus, la couche nanostructurée 82, qui est suspendue au dessus du substrat 84, est unidimensionnelle, et comporte une cavité optique résonante 86 réalisée par l'absence d'un trou dans la ligne nanostructurée à période régulière formée dans une membrane en matériau semi-conducteur. En variante, plusieurs telles lignes nanostructurées, par exemple parallèles, sont présentes dans le dispositif électro-optique.

Avantageusement, un dispositif d'échantillonnage électro-optique fonctionne avec un signal de commande optique de longueur d'onde comprise entre 0,8µm et 1,6µm et avec un temps de commutation de l'ordre de la picoseconde.

## Revendications

1. Dispositif d'échantillonnage électro-optique d'un signal hyperfréquence comprenant une ligne hyperfréquence (20) de transmission d'un signal hyperfréquence, ladite ligne hyperfréquence comportant une zone d'interruption (22) apte à être rendue conductrice sous l'effet d'un signal optique de commande de manière à réaliser une fonction d'interrupteur à commande optique, **caractérisé en ce qu'**il comporte, dans ladite zone d'interruption, une couche (32, 42, 52, 72, 82) en matériau semi-conducteur nanostructuré, comportant un pavage périodique ou quasi-périodique de nanostructures (38), ledit matériau semi-conducteur ayant un indice de réfraction, ladite couche (32, 42, 52, 72, 82) en matériau semi-conducteur nanostructuré étant posée, au niveau de ladite zone d'interruption, en suspension ou sur un matériau diélectrique (36) d'indice de réfraction inférieur à l'indice de réfraction du matériau semi-conducteur, ladite couche (32, 42, 52, 72, 82) en matériau semi-conducteur nanostructuré étant apte à réaliser ladite fonction d'interrupteur à commande optique.

2. Dispositif d'échantillonnage électro-optique selon la revendication 1, **caractérisé en ce que** ladite couche (32, 42, 52, 72, 82) en matériau semi-conducteur nanostructuré comporte au moins une cavité optique résonante (44, 54, 74, 86) formée par modification dans le pavage de nanostructures.

3. Dispositif d'échantillonnage électro-optique selon la revendication 2, **caractérisé en ce que** lesdites nanostructures sont des trous, et **en ce que** ladite modification consiste en une omission, un changement de diamètre ou un déplacement par rapport au pavage d'au moins un trou.

4. Dispositif d'échantillonnage électro-optique selon la revendication 3, **caractérisé en ce que** ladite modification consiste en une omission localisée ou périodique d'un ou de plusieurs trous du pavage.

5. Dispositif d'échantillonnage électro-optique selon l'une des revendications 3 ou 4, **caractérisé en ce que** ledit pavage est une répétition périodique de motifs hexagonaux, et **en ce qu'**il comporte une pluralité de cavités résonantes formées par omission du trou central de chaque motif hexagonal.

6. Dispositif d'échantillonnage électro-optique selon l'une des revendications 2 à 5, **caractérisé en ce que** ladite cavité optique résonante permet une absorption linéaire ou non-linéaire pour un signal optique de commande de longueur d'onde comprise dans une plage de 0,8µm à 1,6µm.

7. Dispositif d'échantillonnage électro-optique selon l'une des revendications 2 à 6, **caractérisé en ce que** ladite cavité optique résonante comporte un dispositif de couplage apte à favoriser l'absorption d'un signal optique de commande d'incidence normale par rapport à la couche (32, 42, 52, 72, 82) en matériau semi-conducteur nanostructuré.

8. Dispositif d'échantillonnage électro-optique selon l'une des revendications précédentes, **caractérisé en ce que** le matériau semi-conducteur formant ladite couche (32, 42, 52, 72, 82) en matériau semi-conducteur nanostructuré est un alliage de la famille de semi-conducteurs III-V.

9. Dispositif d'échantillonnage électro-optique selon l'une des revendications précédentes, **caractérisé en ce que** ladite couche (32, 42, 52, 72, 82) en matériau semi-conducteur nanostructuré a une épaisseur comprise dans une plage de 100 à 400 nanomètres.

10. Dispositif d'échantillonnage électro-optique selon l'une des revendications précédentes, dans lequel le signal de commande optique a une longueur d'onde donnée, **caractérisé en ce que** ledit pavage a une période associée, ladite période étant choisie en fonction de la longueur d'onde du signal optique de commande et de l'indice de réfraction du matériau semi-conducteur formant la couche en matériau semi-conducteur nanostructuré.

## Patentansprüche

1. Vorrichtung zur elektrooptischen Abtastung eines Höchstfrequenzsignals, die eine Höchstfrequenzleitung (20) zur Übertragung eines Höchstfrequenzsignals umfasst, wobei die Höchstfrequenzleitung eine Unterbrechungszone (22) aufweist, die geeignet ist, bei Wirkung eines optischen Steuersignals leitend zu werden, um eine Unterbrechungsfunktion mit optischer Steuerung zu realisieren, **dadurch gekennzeichnet, dass** sie in der Unterbrechungszone eine Schicht (32, 42, 52, 72, 82) aus halbleitendem nanostrukturierten Material aufweist, das einen periodischen oder quasiperiodischen Nanostrukturbelag (38)aufweist, wobei das halbleitende Material einen Brechungsindex hat und die Schicht (32, 42, 52, 72, 82) aus nanostrukturiertem halbleitenden Material an die Unterbrechungszone in Suspension oder auf ein dielektrisches Material (36) mit einem Brechungsindex kleiner als der Brechungsindex des halbleitenden Materials gelegt ist, wobei die Schicht (32, 42, 52, 72, 82) aus nanostrukturiertem Halbleitermaterial geeignet ist, die Unterbrechungsfunktion mit optischer Steuerung zu realisieren.

2. Vorrichtung zur elektrooptischen Abtastung nach Anspruch 1, **dadurch gekennzeichnet, dass** die Schicht (32, 42, 52, 72, 82) aus nanostrukturiertem Halbleitermaterial mindestens einen optischen Resonanzhohlraum (44, 54, 74, 86) aufweist, der durch Modifikation in dem Nanostrukturbelag gebildet ist.

3. Vorrichtung zur elektrooptischen Abtastung nach Anspruch 2, **dadurch gekennzeichnet, dass** die Nanostrukturen Löcher sind und dass die Modifikation in einem Weglassen, einer Durchmesseränderung oder einer Verschiebung mindestens eines Lochs in Bezug auf den Belag besteht.

4. Vorrichtung zur elektrooptischen Abtastung nach Anspruch 3, **dadurch gekennzeichnet, dass** die Modifikation in einer lokalisierten oder periodischen Weglassung eines oder mehrerer Löcher des Belags besteht.

5. Vorrichtung zur elektrooptischen Abtastung nach einem der Ansprüche 3 oder 4, **dadurch gekennzeichnet, dass** der Belag eine periodische Wiederholung von hexagonalen Mustern darstellt, und dass er eine Mehrzahl von Resonanzhohlräumen aufweist, die durch Weglassen eines zentralen Lochs jedes hexagonalen Musters gebildet sind.

6. Vorrichtung zur elektrooptischen Abtastung nach einem der Ansprüche 2 bis 5, **dadurch gekennzeichnet, dass** der optische Resonanzhohlraum eine lineare oder nichtlineare Absorption für ein optisches Steuersignal mit einer Wellenlänge gestattet, die in einem Bereich von 0,8 µm bis 1,6 µm liegt.

7. Vorrichtung zur elektrooptischen Abtastung nach einem der Ansprüche 2 bis 6, **dadurch gekennzeichnet, dass** der optische Resonanzhohlraum eine Koppelvorrichtung aufweist, die geeignet ist, die Absorption eines optischen Steuersignals mit senkrechtem Einfall in Bezug auf die Schicht (32, 42, 52, 72, 82) aus nanostrukturiertem Halbleitermaterial zu favorisieren.

8. Vorrichtung zur elektrooptischen Abtastung nach einem der vorhergehenden Ansprüche, **dadurch gekennzeichnet, dass** das Halbleitermaterial, das die Schicht (32, 42, 52, 72, 82) aus nanostrukturiertem Halbleitermaterial bildet, eine Legierung der Familie von Halbleitern III - V ist.

9. Vorrichtung zur elektrooptischen Abtastung nach einem der vorhergehenden Ansprüche, **dadurch gekennzeichnet, dass** die Schicht (32, 42, 52, 72, 82) aus nanostrukturiertem Halbleitermaterial eine Dicke umfasst, die in einem Bereich von 100 bis 400 Nanometern liegt.

10. Vorrichtung zur elektrooptischen Abtastung nach einem der vorhergehenden Ansprüche, bei der das optische Steuersignal eine gegebene Wellenlänge aufweist, **dadurch gekennzeichnet, dass** der Belag eine zugeordnete Periode hat, wobei die Periode abhängig von der Wellenlänge des optischen Steuersignals und dem Brechungsindex des Halbleitermaterials gewählt ist, das die Schicht aus nanostrukturiertem Halbleitermaterial bildet.

## Claims

1. An electro-optical sampling device for electro-optical sampling of a microwave frequency signal comprising a microwave transmission line (20) for transmitting a microwave signal, the said microwave line comprising an interruption zone (22) able to be rendered conducting under the effect of an optical control signal so as to carry out a function of optically controlled interrupter switch, **characterised in that** it comprises, in the said interruption zone, a layer (32, 42, 52, 72, 82) of nanostructured semiconductor material, comprising a periodic or quasi-periodic tiling of nanostructures (38), the said semiconductor material having a refractive index, the said layer (32, 42, 52, 72, 82) of nanostructured semiconductor material being placed, at the level of the said interruption zone, in suspension or on a dielectric material (36) of lower refractive index than the refractive index of the said semiconductor material, the said layer (32, 42, 52, 72, 82) of nanostructured semiconductor material being able to carry out the said function of optically controlled interrupter switch.

2. An electro-optical sampling device according to claim 1, **characterised in that** the said layer (32, 42, 52, 72, 82) of nanostructured semiconductor material comprises at least one resonant optical cavity (44, 54, 74, 86) formed by modification in the tiling of nanostructures.

3. An electro-optical sampling device according to claim 2, **characterised in that** the said nanostructures are holes, and **in that** the said modification consists of an omission, a change in diameter or a displacement in relation to the tiling of at least one hole.

4. An electro-optical sampling device according to claim 3, **characterised in that** the said modification consists of a localised or periodic omission of one or more holes in the tiling.

5. An electro-optical sampling device according to one of claims 3 or 4, **characterised in that** the said tiling is a periodic repetition of hexagonal patterns, and **in that** it comprises a plurality of resonant cavities formed by omission of the central hole of each hexagonal pattern.

6. An electro-optical sampling device according to one of claims 2 to 5, **characterised in that** the said resonant optical cavity provides for a linear or non-linear absorption for an optical control signal having a wavelength comprised within a range of 0.8 µm to 1.6 µm.

7. An electro-optical sampling device according to one of claims 2 to 6, **characterised in that** the said resonant optical cavity comprises a coupling device capable of promoting the absorption of an optical control signal of normal incidence relative to the layer (32, 42, 52, 72, 82) of nanostructured semiconductor material.

8. An electro-optical sampling device according to one of the preceding claims, **characterised in that** the semiconductor material forming the said layer (32, 42, 52, 72, 82) of nanostructured semiconductor material is an alloy of the family of group III-V semiconductors.

9. An electro-optical sampling device according to one of the preceding claims, **characterised in that** the said layer (32, 42, 52, 72, 82) of nanostructured semiconductor material has a thickness comprised in a range of 100 to 400 nanometres.

10. An electro-optical sampling device according to one of the preceding claims, wherein the optical control signal has a given wavelength, **characterised in that** the said tiling has an associated period, the said period being selected based on the wavelength of the optical control signal and the refractive index of the semiconductor material that forms the layer of nanostructured semiconductor material.
